Europäisches Patentamt

European Patent Office

Office européen des brevets

(19)

(11) **EP 0 546 466 B1**

(12) **EUROPEAN PATENT SPECIFICATION**

(45) Date of publication and mention
of the grant of the patent:
**19.11.1997 Bulletin 1997/47**

(51) Int Cl.6: **H03L 7/197**

(21) Application number: **92120705.6**

(22) Date of filing: **04.12.1992**

(54) **Method and system for reducing the jitter of a PLL (Phase Locked Loop) structure characterized by a rational ratio between input and output frequencies**

Verfahren und System zur Phasenjitterreduzierung in einem Phasenregelkreis mit gebrochenem N-Teilerverhältnis

Méthode et système de réduction de la gigue de phase dans une PLL à rapport de fréquence fractionnaire N

(84) Designated Contracting States:
**DE ES FR GB NL SE**

(30) Priority: **10.12.1991 IT MI913303**

(43) Date of publication of application:
**16.06.1993 Bulletin 1993/24**

(73) Proprietor: **ALCATEL ITALIA S.p.A.**
**20149 Milano (IT)**

(72) Inventors:
• **Cucchi, Silvio**
  **I-20090 Gaggiano (IT)**
• **Ponte, Luca**
  **Mereto (UD) (IT)**

(74) Representative: **Pohl, Herbert, Dipl.-Ing. et al**
**Alcatel Alsthom,**
**Intellectual Property Department,**
**P.O. Box 30 09 29**
**70449 Stuttgart (DE)**

(56) References cited:
**EP-A- 0 429 217**      **WO-A-90/12458**
**WO-A-91/07824**      **WO-A-91/17604**

## Description

Fractional PLLs of the above- mentioned type are well known in the literature and used in the industry, e. g. in (audio, video, etc.) signal transmitters and receivers, in measurement systems using frequency synthesis and in many other applications.

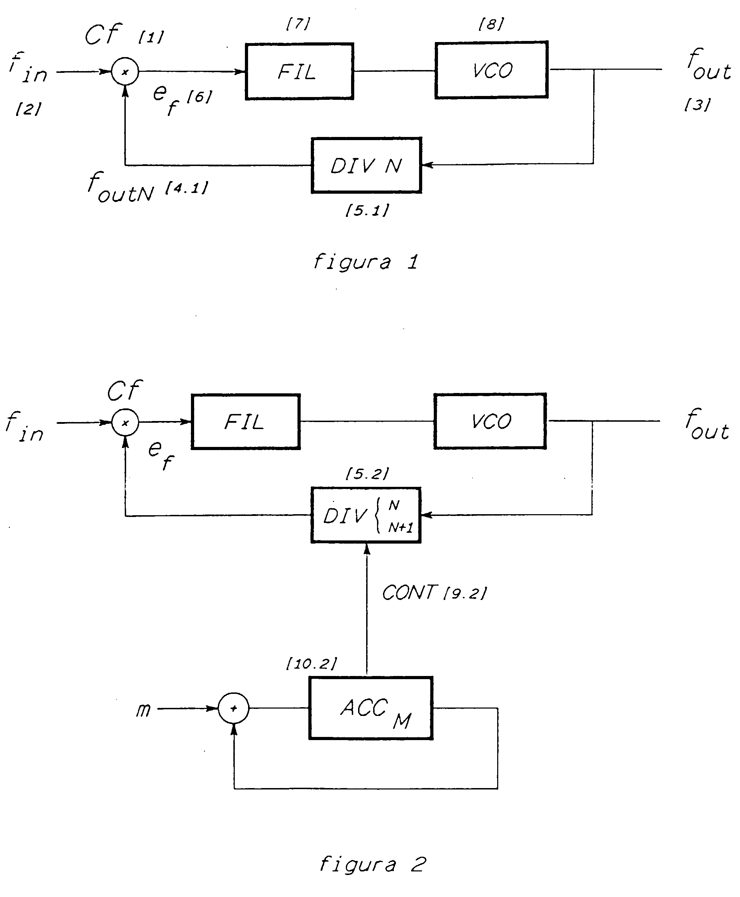

In order to clear up at once and better, it is convenient to analyze the general circuit diagram of a conventional PLL illustrated in fig.1. The function of this system is to generate a frequency fout [3] that is an integral multiple (N) of a frequency fin [2] and phase locked thereto. Let us analyze briefly this circuit. Block Cf [1] is a phase comparator : it is feeded by the reference signal at a frequency fin and by the signal foutN [4.1] whose frequency is equal to fout divided by N (frequency division carried out by block DIV [5.1]). The signal ef [6] which provides a measure of the phase shift between the two signals is obtained at the output of the phase comparator.

The phase error ef passes through a low-pass filter (block FIL [7]) and is used for driving a controlled oscillator (block VCO) [8]). Under ideal operating conditions, the output frequency fout is N times the input frequency fin and the two signals are phase locked.

Often it is necessary that the ratio between the frequencies fout and fin is a rational number

$$\frac{fout}{fin} = \frac{A}{B} \qquad (1)$$

Let us consider the case in which A > B.

The technique usually used for realizing this condition is to represent the ratio as a sum of an integral part and a rational number less than 1.

$$\frac{fout}{fin} = \frac{A}{B} = N + \frac{m}{M} \qquad (2)$$

where N, m, M are integers with m < M.
It can be noted immediately that the ratio fout/fin is comprised between the integers N and N+1.

This condition suggests how to modify the diagram in fig.1 to obtain the desired ratio between the frequencies (diagram in fig.2).

Considering a certain time interval, block DIV [5.2] should divide frequency fout by N during a certain subinterval and by N+1 for the remaining time : as a whole the average frequency fout on the entire interval should be such as to satisfy equation (2).

The diagram illustrated in fig.2 is one of the known possible embodiments which allow to obtain the ratio described by equation (2). By examining the diagram it can be seen that block DIV is driven by a signal CONT [9.2] : let us suppose that CONT is able to assume two possible values to which divisions by N and by N+1 respectively correspond.

Block ACCM [10.2] is a modulo M accumulator that generates signal CONT every M/m cycles of the signal of frequency fin. If signal CONT is present, block DIV divides frequency fout by N+1, otherwise divides it by N. The operation of the system can be summarized by saying that, over a complete cycle of accumulator ACCM, the signal fout is divided by N+1 a number m of times and by N for the remaining M-m times.

By simple calculations it is possible to verify that the average frequency fout over the cycle of accumulator ACCM, (M cycles of the input signal) is such as to satisfy equation (2).

A problem arising from the use of the known diagram in fig. 2 is the low frequency jitter between the signal of frequency fin and the one of fout. The explanation of this phenomenon is the following : the signal CONT generated by ACCM is normally at value 0 and assumes value 1 only every M/m cycles of signal fin. The result is that divider DIV divides fout by N+1 only every M/m cycles of the signal of frequency fin and by N during the remaining cycles. When block DIV divides by N (which is smaller than ratio A/B that we would obtain) frequency fout/N is higher than desired : the phase error between fin and fout (measured by the phase comparator Cf) then increases linearly with time. Similarly, when dividing by N+1, the frequency fout/N+1 is smaller than the one described by ratio (2) and the phase error still increases linearly with time, but it has opposite sign with respect to the preceding case.

The output signal ef from the phase comparator has a saw-tooth waveform with a period equal to M/m times the period of the input signal fin. If the ratio M/m is high, a slow drift of the signal of frequency fout, with respect to the input signal, occurs. This drawback can jeopardize the correct operation of the system in which the PLL is included.

In WO 91/07824 an indirect frequency synthesizer for use in a cellular radio system is described. The synthesizer comprises a phase detector responsive to a reference signal and a phase control signal for generating a control signal that varies in the dependence upon the phase difference between the reference signal and the phase control signal. A voltage controlled oscillator responsive to the control signal generates an output signal whose frequency varies in the dependence upon the control signal. A variable modulus divider divides the output signal to provide the phase control signal. The variable modulus divider varies ist division ratio in dependence upon a ratio control signal derived by a second or higher order sigma-delta modulator in response to a frequency control signal and to the phase control signal.

In WO 91/17604 a fractional-N synthesizer employing at least a second order sigma-delta modulator is described. The most significant bit from the output accumulator of the sigma-delta modulator are used as the carry out control for the variable divisorof the loop divider. Modulation to the synthesizer is introduced as part of the digital number input to sigma-delta modulator and spurious signal output is reduced by selection of a large number as the denominator of the fractional portion of the loop divider divisor.

An object of the present invention is to provide a method and a system for reducing the jitter between the input and the output signal of a PLL.

This object is attained with a method according to claim 1 and a PLL device according to claim 5.

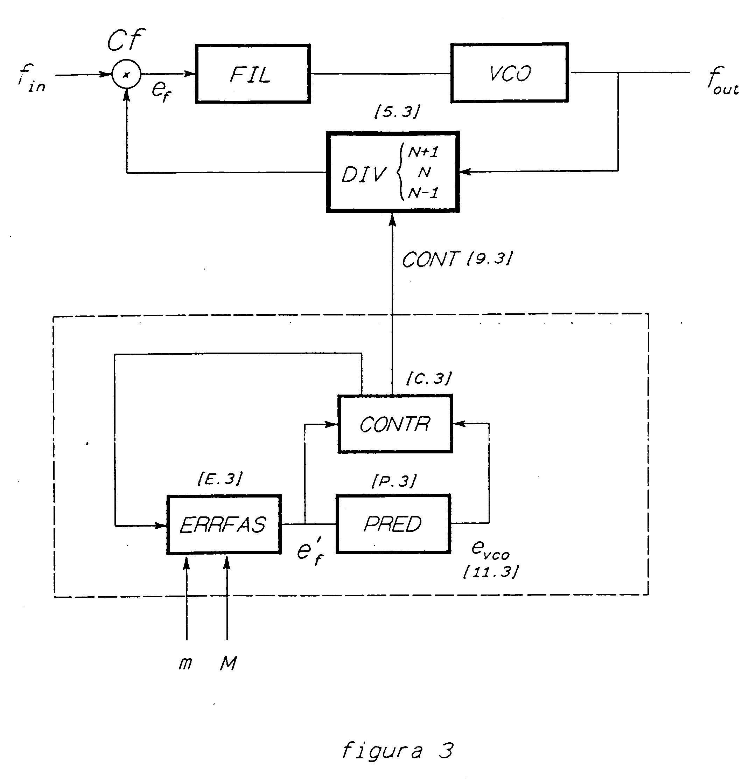

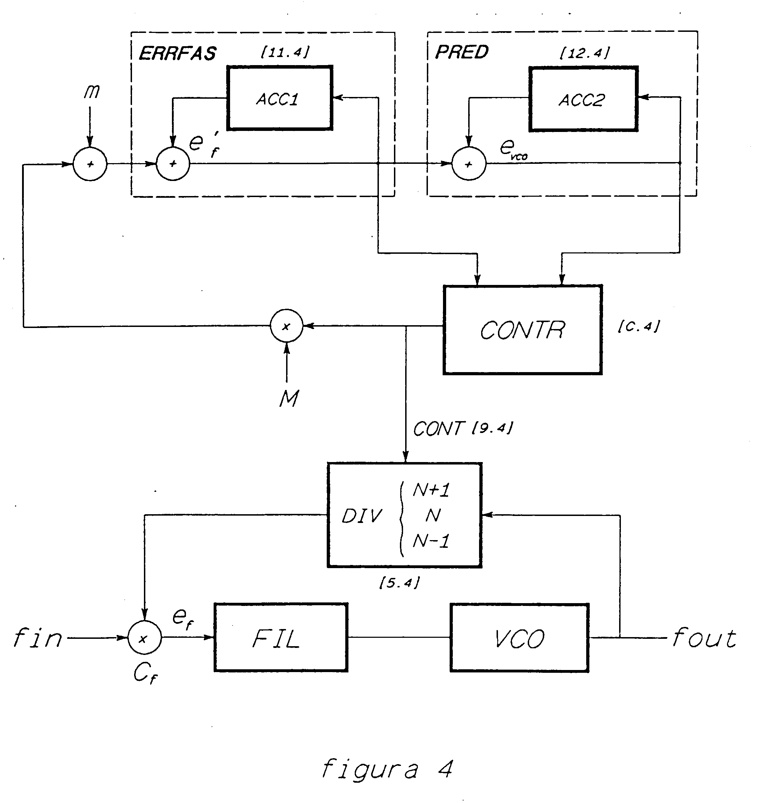

In the following an example of an embodiment of the invention is described referring to fig. 3 and 4.

Fig. 3 shows a block diagram of the inventive system and

Fig. 4 shows the block diagram of Fig. 3 in more detail.

Fig. 3 illustrates the block diagram of the system. According to one aspect of the invention, the frequency divider DIV [5.3] now can divide fout also by N-1 besides by N and N+1 (N must be calculated by reaching a round figure of the ratio A/B of equation (2) corresponding to the closest integer).

In the lower portion of the diagram in fig. 3 there are three basic blocks which constitute the frequency divider control system :

- ERRFAS [E.3] : phase error reproducer, since its function is to reproduce the output phase error ef of comparator Cf.
- PRED [P.3] : is a predictor that provides an estimate of the phase error $^e$VCO [11.3] of the signal generated by the controlled oscillator (VCO).
- CONTR [C.3] : is a control block which, by using information on the output phase error e'f of the comparator (reproduced by ERRFAS) and information $^e$VCO (provided by PRED) selects the most opportune division value in order to minimize the phase error at the VCO output.

In fig.4 there is illustrated a special embodiment of the general diagram in fig. 3. In the simplest version, predictor PRED can be realized by an integrator (first order prediction) but there is nothing to prevent us from using more complex predictors according to the accuracy level with which one wants to simulate the system comprised of filter FIL and VCO in fig.4.

Let us analyze how the control sequence for the divider is realized.

Block DIV [5.4] can divide by N or N+1 or N-1 according as the signal assumes the values 0, -1, +1. The control system CONTR [C. 4] picks up signals e'f (phase error reproduced in ERRFAS) and $^e$VCO (phase error estimated on VCO).

Let us assume that division of frequencies by N+1 gives rise to a phase shift a between fin and fout represented by + M on accumulator ACC1 [11.4], while division by N-1 gives rise to a phase shift equal to -M (signs depend upon convention established on comparator Cf).

If the control block CONTR sends a command CONT not equal to zero, it is necessary to update consequently accumulator ACC1 so that phase error e'f reproduced by ACC1 is consistent with ef measured by comparator Cf. If CONT = 1, the value M is added to ACC1 ; finally if CONT = - 1 the same value is subtracted.

At each instant block CONTR has to decide, on the ground of values of e'f (reproduced by ERRFAS) and $^e$VCO (produced by PRED) whether to send divisor DIV [5.4] the command to divide by N, N-1 or N+1.

The goal of the invention is to obtain an output phase error of the phase comparator which has a zero mean value and spectral content concentrated in the high frequencies (out of the passband of filter FIL). In other words it is desired to pass from a low frequency jitter to a high frequency one which can be filtered at the output of PLL.

Still referring to fig. 4, in order to obtain this condition, block CONTR examines the effect on $^e$VCO of the three possible division choices and decides to adopt the one which causes the minimum absolute error.

At each instant (the clock is bound to frequency fin) block CONTR has to carry out the three tests :

- division by N : the estimate of VCO phase error is calculated by adding the contribution e'f from ACC1 to the value of $^e$VCO ;
- division by N+1 : the estimate of the VCO phase error is calculated by adding to $^e$VCO actual value the contribution e'f from ACC1 and the value M that takes into account the effect on the phase error consequent to division by N+1 ;
- division by N-1 : the estimate of the VCO phase error is calculated by adding to $^e$VCO actual value the contribution e'f from ACC1 and substracting the value M that takes into account the division by N-1.

The choice of the division value to be used is the one to which the minimum absolute value of $^e$VCO calculated with the three modes just set forth, corresponds.

Although the invention has been described with reference to the only embodiments illustrated in the drawings, it is obviously susceptible to variations, modifications, replacements and the like which, being apparent to those skilled in the art, naturally fall within the scope of the invention as set forth in the attached claims.

**Claims**

1. Method of controlling a PLL oscillator for generating at the output thereof a frequency in which: the ratio between the output frequency (fout) from the PLL and a reference frequency (fin) is a rational number; said PLL output frequency (fout) is divided by a frequency divider (DIV) by a number N or N+1 or N-1 and compared with the reference frequency (fin) in a phase comparator (Cf); the phase error produced by the phase comparator (Cf) is filtered and used for driving the controlled oscillator (VC0) of the PLL, characterized in that on the ground of said phase error produced by the phase comparator (Cf) an estimate of the phase error (eVC0) of the signal generated by the controlled oscillator (VC0) is carried out, and from said estimate of the phase error (eVC0) and said phase error produced by said phase comparator (Cf) a driving signal is obtained for selecting the division value of said frequency divider (DIV) which minimizes said phase error (eVC0) of the signal generated by the voltage controlled oscillator (VC0).

2. Method according to claim 1, characterized in that the frequency divider (DIV) provides that the spectral contents of the jitter on the PLL output signal is concentrated at high frequency and can be easily eliminated by filtering the PLL output signal itself.

3. Method according to any of the preceding claims, characterized in that said output error of the phase comparator (Cf) is reproduced by a reproducing circuit (ERRFAS).

4. Method according to claim 3, wherein m/M represents the fractional portion of the division ratio between the output frequency (fout) from the PLL and a reference frequency (fin), characterized in that when dividing said output frequency (fout) by N, the only contribution of the phase error (e'f) reproduced in the reproducing circuit (ERRFAS) is added to the estimated value of the oscillator phase error (eVC0); when dividing said output frequency (fout) by N-1, said contribution of the phase error (e'f) reproduced but subtracted by M is added to the estimated value of the oscillator phase error (eVC0); when dividing said output frequency (fout) by N+1, said contribution of the phase error (e'f) reproduced but added up together with M is added to the estimated value of the oscillator phase error (eVC0).

5. A PLL device comprising a programmable frequency divider (DIV) connected to a controlled oscillator (VC0) to divide its output frequency (fout), said programmable frequency divider (DIV) being enabled to divide said output frequency (fout) by at least three values N, N-1 and N+1, and comprising a phase comparator (Cf) to respective inputs of which a reference frequency (fin) and the divided oscillator output frequency (FoutN) are applied, said PLL device further comprises a filter (FIL) for filtering the phase error produced by the phase comparator (CF) and a control system (CONTR) for controlling the dividing value of said programmable frequency divider (DIV), characterized in that said control system being fed by a reproducing circuit (ERRFAS) reproducing the output phase error of the phase comparator (Cf) and by a predicting circuit (PRED) connected to said reproducing circuit (ERRFAS) for estimating the phase error (eVC0) of the signal generated by the controlled oscillator (VC0), said control system (CONTR) being coupled to said programmable frequency divider (DIV) for selecting therein the dividing value which minimizes said phase error (eVC0) of the signal generated by the voltage controlled oscillator (VC0).

6. Device according to claim 5, characterized in that the reproducing circuit (ERRFAS) and the predicting circuit (PRED) are constituted by integrators.

**Patentansprüche**

1. Methode zur Steuerung eines PLL-Oszillators, um an seinem Ausgang eine Frequenz zu erzeugen, für die das Verhältnis zwischen der Ausgangsfrequenz (fout) der PLL und einer Bezugsfrequenz (fin) eine rationale Zahl ist; die PLL-Ausgangsfrequenz (fout) von einem Frequenzteiler (DIV) durch eine Zahl N oder N+1 oder N-1 geteilt und mit der Bezugsfrequenz (fin) in einem Phasenvergleicher (Cf) verglichen wird; der vom Phasenvergleicher (Cf) erzeugte Phasenfehler gefiltert und zur Steuerung des gesteuerten Oszillators (VCO) der PLL benutzt wird, dadurch gekennzeichnet, daß auf der Grundlage des Phasenfehlers, der vom Phasenvergleicher (Cf) erzeugt wurde, eine Schätzung des Phasenfehlers (eCVO) des vom gesteuerten Oszillator (VCO) erzeugten Signals durchgeführt wird, und von dieser Schätzung des Phasenfehlers (eCVO) und dem Phasenfehler, der vom Phasenvergleicher (Cf) erzeugt wurde, ein Steuersignal zur Auswahl des Divisionswertes des Frequenzteilers (DIV) erhalten wird, das den Phasenfehler (eCVO) des Signals minimiert, das von dem spannungsgesteuerten Oszillator (VCO) erzeugt wurde.

2. Methode gemäß Anspruch 1, dadurch gekennzeichnet, daß der Frequenzteiler (DIV) dafür sorgt, daß der Spektralgehalt des Jitters am PLL-Ausgangssignal bei hoher Frequenz konzentriert ist und leicht durch Filterung des PLL-Ausgangssignals entfernt werden kann.

3. Methode gemäß einem der vorhergehenden Ansprüche, dadurch gekennzeichnet, daß der Ausgangs fehler des Phasenvergleichers (Cf) durch eine Reproduktionsschaltung (ERRFAS) reproduziert wird.

4. Methode gemäß Anspruch 3, wobei m/M den gebrochenen Anteil des Teilungsverhältnisses zwischen der Ausgangsfrequenz (fout) der PLL und einer Bezugsfrequenz (fin) darstellt, dadurch gekennzeichnet, daß, wenn die Ausgangsfrequenz (fout) durch N dividiert wird, der einzige Beitrag des Phasenfehlers (e'f), der in der Reproduktionsschaltung (ERRFAS) reproduziert wird, zum geschätzten Wert des Oszillatorphasenfehlers (eCVO) addiert wird; wenn die Ausgangsfrequenz (fout) durch N-1 dividiert wird, der Beitrag des Phasenfehlers (e'f) reproduziert, aber um M verringert, zum geschätzten Wert des Oszillatorphasenfehlers (eVCO) addiert wird; wenn die Ausgangsfrequenz (fout) durch N+1 dividiert wird, der Beitrag des Phasenfehlers (e'f) reproduziert, aber um M erhöht, zum geschätzten Wert des Oszillatorphasenfehlers (eVCO) addiert wird.

5. PLL-Gerät, das einen programmierbaren Frequenzteiler (DIV) umfaßt, der mit einem gesteuerten Oszillator (VCO) verbunden ist, um seine Ausgangsfrequenz (fout) zu teilen, wobei der programmierbare Frequenzteiler (DIV) imstande ist, die Ausgangsfrequenz (fout) durch wenigstens drei Werte N, N-1 und N+1 zu teilen, und das einen Phasenvergleicher (Cf) umfaßt, an dessen jeweilige Eingänge eine Bezugsfrequenz (fin) und die geteilte Oszillatorausgangsfrequenz (FoutN) angelegt werden, wobei das PLL-Gerät weiterhin ein Filter (FIL) zur Filterung des Phasenfehlers, der von dem Phasenvergleicher (Cf) erzeugt wurde, und ein Steuersystem (CONTR) zur Steuerung des Teilungswertes des programmierbaren Frequenzteilers (DIV) umfaßt, dadurch gekennzeichnet, daß das Steuersystem durch eine Reproduktionsschaltung (ERRFAS) gespeist wird, die den Ausgangsphasenfehler des Phasenvergleichers (Cf) reproduziert, sowie durch eine Vorhersageschaltung (PRED), die mit der Reproduktionsschaltung (ERRFAS) verbunden ist, um den Phasenfehler (eCVO) des Signals zu schätzen, das von dem gesteuerten Oszillator (VCO) erzeugt wurde, wobei das Steuersystem (CONTR) mit dem programmierbaren Frequenzteiler (DIV) verbunden ist, um dort den Teilerwert auszuwählen, der den Phasenfehler (eCVO) des Signals minimiert, das von dem spannungsgesteuerten Oszillator (VCO) erzeugt wurde.

6. Gerät gemäß Anspruch 5, dadurch gekennzeichnet, daß die Reproduktionsschaltung (ERRFAS) und die Vorhersageschaltung (PRED) von Integratoren gebildet werden.

**Revendications**

1. Méthode de contrôle d'un oscillateur PLL pour la génération à la sortie de ce dernier d'une fréquence pour laquelle le rapport entre la fréquence de sortie (fout) du PLL et une fréquence de référence (fin) est un nombre rationnel; la fréquence de sortie PLL mentionnée (fout) est divisée par un diviseur de fréquence (DIV) par un nombre N ou N+1 ou N-1 puis comparée à la fréquence de référence (fin) dans un comparateur de phase (Cf); l'erreur de phase produite par le comparateur de phase (Cf) est filtrée et utilisée pour la commande de l'oscillateur contrôlé (VCO) du PLL, _caractérisée par le fait que,_ sur la base de ladite erreur de phase produite par le comparateur de phase (Cf), une estimation de l'erreur de phase (eVCO) du signal généré par l'oscillateur contrôlé (VCO) est réalisée et, à partir de cette estimation de l'erreur de phase (eVCO) et de l'erreur de phase produite par le comparateur de phase (Cf) mentionné, un signal de commande est obtenu pour la sélection de la valeur du diviseur de fréquence (DIV) mentionné, laquelle minimise l'erreur de phase (eVCO) du signal généré par l'oscillateur à tension contrôlée (VCO).

2. Méthode conformément à la revendication 1, _caractérisée par le fait que_ le diviseur de fréquence (DIV) garantit que les composantes spectrales du décrochement du signal de sortie PLL sont concentrées à une haute fréquence et peuvent facilement être éliminées par filtration du signal de sortie PLL lui-même.

3. Méthode conforme à l'une quelconque des revendications précédentes, _caractérisée par le fait que_ l'erreur de sortie en question du comparateur de phase (Cf) est reproduite par un circuit reproducteur (ERRFAS).

4. Méthode conformément à la revendication 3 pour laquelle m/M représente la fraction du rapport de division entre la fréquence de sortie (fout) du PLL et une fréquence de référence (fin), _caractérisée par le fait que,_ lorsqu'on divise la fréquence de sortie (fout) en question par N, la part unique de l'erreur de phase (e'f) reproduite dans le circuit reproducteur (ERRFAS) est ajoutée à la valeur estimée de l'erreur de phase d'oscillateur (eVCO); en divisant la fréquence de sortie (fout) en question par N-1, ladite part de l'erreur de phase (e'f) reproduite dans le circuit reproducteur (ERRFAS), minorée de M, est ajoutée à la valeur estimée de l'erreur de phase d'oscillateur (eVCO); en divisant la fréquence de sortie (fout) en question par N+1, ladite part de l'erreur de phase (e'f) reproduite dans le circuit reproducteur (ERRFAS), majorée de M, est ajoutée à la valeur estimée de l'erreur de phase d'oscillateur (eVCO).

5. Un dispositif PLL se composant d'un diviseur de fréquence (DIV) raccordé à un oscillateur contrôlé (VCO) pour la division de la fréquence de sortie (fout) de ce dernier, le diviseur de fréquence (DIV) en question pouvant diviser ladite fréquence de sortie (fout) au moins par trois valeurs N, N-1 et N+1, et comportant un comparateur de phase (Cf) aux entrées duquel une fréquence de référence (fin) et la fréquence de sortie divisée de l'oscillateur (FoutN) sont appliquées; le dispositif PLL en question comporte par ailleurs un filtre (FIL) pour la filtration de l'erreur de phase produite par le comparateur de phase (Cf) et un système de contrôle (CONTR) pour le contrôle de la valeur du diviseur de fréquence programmable en question, <u>caractérisé par le fait que</u> le système de contrôle mentionné est alimenté par un circuit reproducteur (ERRFAS) reproduisant l'erreur de phase de sortie du comparateur de phase (Cf) et par un circuit de prévision (PRED) raccordé au circuit reproducteur (ERRFAS) pour l'estimation de l'erreur de phase (eVCO) du signal généré par l'oscillateur contrôlé, ledit système de contrôle (CONTR) étant couplé au diviseur de fréquence programmable (DIV) pour la sélection du diviseur minimisant l'erreur de phase (eVCO) en question du signal généré par l'oscillateur à tension contrôlée (VCO).

6. Dispositif conformément à la revendication 5, <u>caractérisé par le fait que</u> le circuit reproducteur (ERRFAS) et le circuit de prévision (PRED) sont constitués par des intégrateurs.

Cf [1]

$f_{in}$

[2]

$e_f$ [6]

[7] FIL

[8] VCO

$f_{out}$

[3]

DIV N

$f_{outN}$ [4.1]

[5.1]

figura 1

Cf

$f_{in}$

$e_f$

FIL

VCO

$f_{out}$

[5.2]

DIV $\left\{ \begin{matrix} N \\ N+1 \end{matrix} \right.$

CONT [9.2]

[10.2]

m

$ACC_M$

figura 2

figura 3

figura 4